Europäisches Patentamt

European Patent Office

Office européen des brevets

(19)

(11) Veröffentlichungsnummer : **0 106 943**
**B1**

(12) **EUROPÄISCHE PATENTSCHRIFT**

(45) Veröffentlichungstag der Patentschrift :
04.03.87

(21) Anmeldenummer : 83107001.6

(22) Anmeldetag : 16.07.83

(51) Int. Cl.⁴ : **H 01 L 43/06**, G 01 R 33/06

(54) **Halleelement.**

(30) Priorität : 30.08.82 CH 5136/82

(43) Veröffentlichungstag der Anmeldung :
02.05.84 Patentblatt 84/18

(45) Bekanntmachung des Hinweises auf die Patenterteilung : 04.03.87 Patentblatt 87/10

(84) Benannte Vertragsstaaten :
DE FR GB IT NL

(56) Entgegenhaltungen :
FR-A- 2 438 345
FR-A- 2 504 272
GB-A-   895 629
GB-A- 2 029 973
GB-A- 2 064 140
US-A- 3 693 085
US-A- 3 789 311
US-A- 4 048 648
US-A- 4 123 772
US-A- 4 240 059
US-A- 4 309 655
PATENTS ABSTRACTS OF JAPAN, Band 6, Nr. 200, 9.
Oktober 1982, Seite 1078 - E-135
IBM TECHNICAL DISCLOSURE BULLETIN, Band 18,
Nr. 8, Januar 1976, Seiten 2745-2748, New York, US,
C.H. BAJOREK: "Magnetoresistive Current Sensor"

(73) Patentinhaber : LGZ LANDIS & GYR ZUG AG

CH-6301 Zug (CH)

(72) Erfinder : Popovic, Radivoje
Zugerstrasse 24
CH-6312 Steinhausen (CH)
Erfinder : Baltes, Heinrich Peter
University of Alberta
Edmonton Alberta T6G 2E1 (CA)

(74) Vertreter : Müller, Hans-Jürgen, Dipl.-Ing. et al
Müller, Schupfner & Gauger Lucile-Grahn-Strasse 38
Postfach 80 13 69
D-8000 München 80 (DE)

## Beschreibung

### Anwendungsgebiet und Zweck

Die Erfindung bezieht sich auf ein Hallelement gemäss dem Oberbegriff des Anspruchs 1. Ein solches Hallelement dient z. B. dem Messen der Stärke eines Magnetfeldes, dem es ausgesetzt ist.

### Stand der Technik

Bekannt ist, dass der sogenannte « Shunt-Effekt » eines Hallelementes, d. h. die Reduktion der Hallspannung in der Nähe seiner Speiseelektroden durch diese metallenen Elektroden, stark reduziert werden kann durch Verwendung von kreuzförmigen Hallelementen.

Aus Solid-State Electronics Pergamon Press 1966, Vol. 9, pp 571-580, Gallagher and Corak, « A Metal-Oxide-Semiconductor (MOS) Hall Element » ist die Funktionsweise und der Einsatz von MOS-Transistoren als sogenannte MOS-Hallelemente bekannt. Ferner ist ein Hallelement gemäß dem ersten Teil des Anspruchs 1 aus dem Dokument Patent Abstracts of Japan, Bd. 6, Nr. 200, 09-10-82, S. 1078-E-135, JP-A-57 107 087, bekannt.

### Aufgabe und Lösung

Der Erfindung liegt die Aufgabe zugrunde, den durch die metallenen Speiseelektroden bedingten « Shunt-Effekt » von Hallelementen weiter zu reduzieren und dadurch die Empfindlichkeit dieser Hallelemente eine Grössenordnung über denjenigen Wert zu erhöhen, den die im Stand der Technik beschriebenen Hallelemente besitzen, d. h. ihrer Empfindlichkeit einen Wert von annähernd 1 Volt/Tesla zu geben.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen :

Figur 1  ein quaderförmiges Hallelement mit Stromquelle,

Figur 2  ein kreuzförmiges Hallelement,

Figur 3  ein Hallelement mit einer Vielzahl von Teilstromquellen,

Figur 4  ein Hallelement mit einer Vielzahl von MOS-Transistor-Teilstromquellen,

Figur 5  einen Querschnitt einer ersten Variante eines MOS-Hallelementes mit Speisung,

Figur 6  eine Draufsicht der ersten Variante eines MOS-Hallelementes mit Speisung,

Figur 7  ein elektrisches Schaltbild der ersten Variante eines MOS-Hallelementes mit Speisung,

Figur 8  eine Draufsicht einer zweiten Variante eines MOS-Hallelementes mit Speisung,

Figur 9  ein elektrisches Schaltbild der zweiten Variante eines MOS-Hallelementes mit Speisung,

Figur 10  einen Querschnitt einer dritten Variante eines MOS-Hallelementes mit Speisung,

Figur 11  eine Draufsicht der dritten Variante eines MOS-Hallelementes mit Speisung,

Figur 12  ein elektrisches Schaltbild der dritten Variante eines MOS-Hallelementes mit Speisung,

Figur 13  einen Querschnitt einer vierten Variante eines MOS-Hallelementes mit Speisung,

Figur 14  eine Draufsicht der vierten Variante eines MOS-Hallelementes mit Speisung und

Figur 15  ein elektrisches Schaltbild der vierten Variante eines MOS-Hallelementes mit Speisung.

Gleiche Bezugszahlen bezeichnen in allen Figuren der Zeichnung gleiche Teile.

### Beschreibung

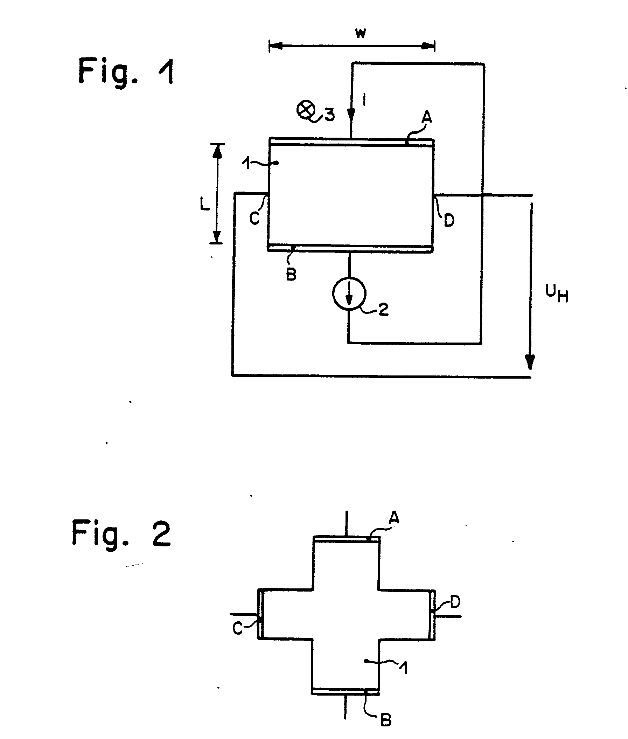

In der Fig. 1 ist ein bekanntes quaderförmiges Hallelement 1 dargestellt, das von einer Stromquelle 2 gespeist und einem senkrecht zur Papierebene wirkenden Magnetfeld 3 ausgesetzt ist. Zwei gegenüberliegende, zum Magnetfeld 3 parallele Seiten des Hallelementes 1 sind mit je einer metallenen Elektrode A bzw. B bedeckt, die je mit einem Pol der Stromquelle 2 verbunden sind. Die beiden anderen gegenüberliegenden und zum Magnetfeld 3 parallelen Seiten des Hallelementes 1 besitzen in ihrer Mitte je einen z. B. punktförmigen Abgriff C bzw. D, welche beide den zweipoligen Hallausgang C, D des Hallelementes 1 bilden. Die Hallspannung $U_H$ am Hallausgang C, D beträgt $U_H = k.l.H$, wobei k eine Konstante, l den Wert des Speisestromes und H denjenigen des Magnetfeldes 3 bedeuten. Der Abstand zwischen den beiden Elektroden A und B wird als länge L bezeichnet, da er bei einem MOS-Hallelement der Länge eines MOS-Transistors entspricht. Die Entfernung zwischen den Abgriffen C und D sellt die Breite W des Hallelementes 1 dar.

Je näher die Abgriffe C und D bei einer der beiden Elektroden A oder B liegen, je kleiner ist die Hallspannung $U_H$, da die metallene Elektrode A bzw. B in diesem Fall als Kurzschluss wirkt. Diese Tatsache ist, wie bereits erwähnt, als « Shunt-Effekt » bekannt. Bei Verwendung nicht punktförmiger Abgriffe C und D wird diesem Effekt bei bekannten herkömmlichen Hallelementen entgegengewirkt, indem dem Hallelement 1 eine kreuzförmige Gestalt gegeben wird gemäss der Fig. 2. Hier dient praktisch nur mehr der horizontale Querbalken CD des Kreuzes der Erzeugung der Hallspannung $U_H$, und da dieser Querbalken relativ weit durch den senkrechten Balken AB des Kreuzes von den beiden Elektroden A und B entfernt ist, wirkt sich der « Shunt-Effekt » nur mehr sehr schwach aus.

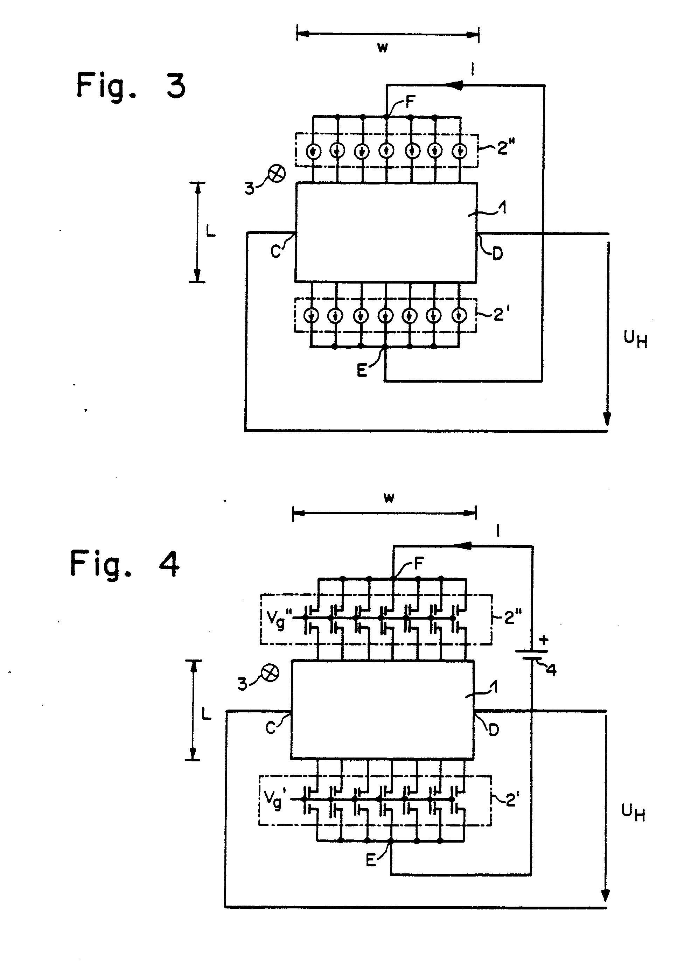

In der Fig. 3 ist ein Hallelement dargestellt, welches theoretisch einen unendlich kleinen « Shunt-Effekt » besitzt. Die Fig. 3 unterscheidet sich von der Fig. 1 dadurch, dass das Hallelement 1 keine metallenen Elektroden A und B mehr besitzt und dass die Stromquelle 2 durch die elektrische Reihenschaltung einer ersten Stromquelle 2' mit einer zweiten Stromquelle 2" ersetzt ist, wobei jede dieser beiden Stromquellen 2' und 2" aus einer möglichst grossen Zahl von Teilstromquellen besteht, die das Hallelement 1 parallel zueinander, jedoch an verschiedenen Orten je einer seiner zwei gegenüberliegenden Breitseiten speisen. Diese Teilstromquellen können diskrete, aber auch kontinuierlich über die ganze Breite W des Hallelementes verteilte Teilstromquellen sein. Jede Teilstromquelle ist z. B. ein MOS-Transistor, wobei dann alle MOS-Transistoren von einer gemeinsamen Spannungsquelle 4 gemäss der Fig. 4 gespeist werden. Die Fig. 4 unterscheidet sich von der Fig. 3 nur dadurch, dass alle Teilstromquellen MOS-Transistoren sind und dass der gemeinsame Pol E aller Teilstromquellen der ersten Stromquelle 2' mit dem negativen und der gemeinsame Pol F aller Teilstromquellen der zweiten Stromquelle 2" mit dem positiven Pol der Spannungsquelle 4 verbunden sind. Diese beiden Pole E und F übernehmen in der Fig. 3 und in der Fig. 4 praktisch die Rolle der Elektroden A und B der Fig. 1 und sind im Gegensatz zu den letzteren nur über die hochohmigen Innenwiderstände der verschiedenen Teilstromquellen mit dem Hallelement 1 verbunden. Dies bedeutet, dass der starke Kurzschlussstrom zwischen nichtpunktförmigen Abgriffen C und D über die Elektroden A und B der Fig. 1 durch einen äusserst schwachen elektrischen Strom über die Innenwiderstände der verschiedenen Teilstromquellen der Fig. 3 bzw. der Fig. 4 ersetzt wurde. Dieser äusserst schwache, vernachlässigbare Strom hat im Gegensatz zum Kurzschlussstrom kaum noch einen Einfluss auf die Hallspannung $U_H$, oder mit anderen Worten, der « Shunt-Effekt » ist praktisch auf Null reduziert worden, womit eine maximale Empfindlichkeit des Hallelementes 1 erreicht ist.

Die Gates aller MOS-Transistoren der ersten Stromquelle 2' sind miteinander verbunden und liegen an einer ersten Steuerspannung $V'_g$. Das Gleiche gilt für die Gates aller MOS-Transistoren der zweiten Stromquelle 2", die an einer zweiten Steuerspannung $V''_g$ liegen.

Nachfolgend werden einige als Varianten bezeichnete Ausführungsbeispiele von mit MOS-Transistor-Teilstromquellen gespeisten MOS-Hallelementen beschrieben. In diesen Fällen bestehen nicht nur die Teilstromquellen, sondern auch das eigentliche Hallelement aus MOS-Transistoren. Die Funktion eines MOS-Hallelementes ist aus dem angegebenen Stand der Technik bekannt. Die nachfolgenden Beispiele werden an Hand von NMOS-Transistoren beschrieben. Es können natürlich auch PMOS-Transistoren verwendet werden, unter Berücksichtigung der dann üblichen, von der MOS-Transistortechnik her bekannten Materialtypen-Abänderungen.

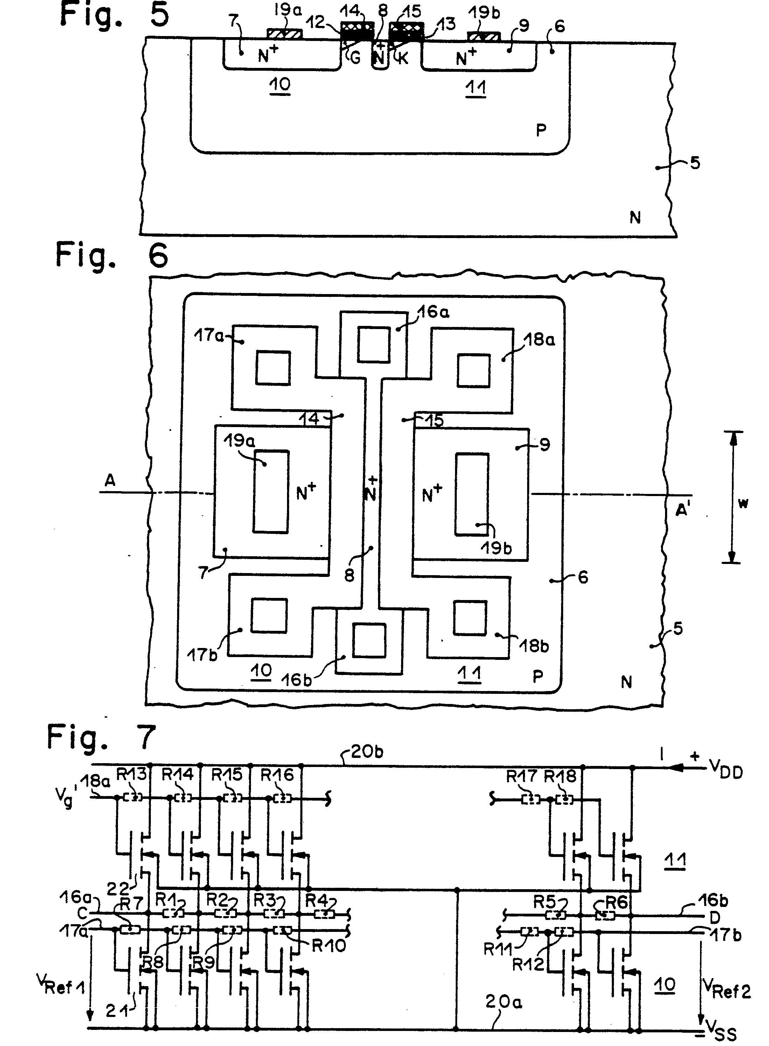

In der Fig. 5 und der Fig. 6 sind Ansichten einer ersten Variante eines MOS-Hallelementes mit Stromspeisungsanordnung dargestellt. Dieses Hallelement besteht aus einem Substrat 5, in das eine Wanne 6 eindiffundiert wurde. In der Wanne 6 sind ihrerseits je eine stark dotierte Source-Halbleiterzone 7, eine zentrale dotierte Halbleiterzone 8 und eine Drain-Halbleiterzone 9 eindiffundiert. Die Wanne 6 und die Halbleiterzonen 7, 8 und 9 besitzen alle annähernd rechteckförmige Querschnitte. Sie sind längs der Achse AA' und symmetrisch zu dieser Achse angeordnet. Die zentrale Halbleiterzone 8 liegt zwischen der Source- und der Drain-Halbleiterzone 7 und 9. Das MOS-Hallelement mit seiner Speisung besteht praktisch aus zwei elektrisch in Reihe geschalteten MOS-Transistoren 10 und 11. Der Kanal des ersten MOS-Transistors 10 liegt zwischen der Source- und der zentralen Halbleiterzone 7 und 8 und derjenigen des zweiten MOS-Transistors 11 zwischen der Drain- und der zentralen Halbleiterzone 9 und 8. Die zentrale Halbleiterzone 8 ist daher gleichzeitig die Drain-Halbleiterzone des ersten und die Source-Halbleiterzone des zweiten MOS-Transistors 10 bzw. 11. Diese beiden letzten sind z. B. als bekannte Anreicherungstransistoren (« Enhancement transistors ») aufgebaut, und arbeiten im Sättigungsbereich, d. h. die Inversionsschicht G bzw. K ihres jeweiligen Kanals, deren Querschnitt in der Fig. 5 jeweils als Dreieck dargestellt ist, reicht von der jeweiligen Source ausgehend nur über einen Teil der Kanallänge. Mit anderen Worten, jeder Transistor-Kanal besitzt in der Darstellung der Fig. 5 rechts von seiner Inversionsschicht G bzw. K einen nur schwach leitenden Teil. Die Kanäle der beiden Transistoren 10 und 11 sind je mit einer $SiO_2$-Schicht 12 bzw. 13 abgedeckt (Gate-Oxyd), deren jede ihrerseits mit einer Gate-Elektrodenschicht 14 bzw. 15 aus Polysilizium bedeckt ist. Die Kanten der $SiO_2$-Schicht 12 bzw. 13 sind einerseits mit den Kanten der zugehörigen Gate-Elektrodenschicht 14 bzw. 15 und anderseits mit der angrenzenden Kante der Source- bzw. Drainhalbleiterzone 7 bzw. 9 sowie der angrenzenden Kante der zentralen Halbleiterzone 8 bündig.

In der Darstellung der Fig. 5 fliesst der elektrische Strom parallel zur Blattseite und von rechts nach links von der Drainzur Sourcehalbleiterzone. Die Abmessung eines Transistorkanals in der Stromflussrichtung wird als Kanallänge bezeichnet. Senkrecht zu dieser Stromflussichtung besitzen beide Transistoren 10 und 11 annähernd gleiche Breiten.

Wie aus der Fig. 6 ersichtlich, besitzt die zentrale Halbleiterschicht 8 an ihren beiden Enden, quer zur Stromflussrichtung der MOS-Transistoren betrachtet, je eine z. B. rechteckförmige Anschlussfahne 16a und 16b. Das Gleiche gilt für die Gate-Elektrodenschicht 14 des ersten MOS-Transistors 10 mit den Anschlussfahnen 17a und 17b und für die Gate-Elektrodenschicht 15 des zweiten MOS-Transistors 11 mit den Anschlussfahnen 18a und 18b. Diese Anschlussfahnen sowie die Source- und Drain-Halbleiterzonen 7 und 9 besitzen je eine z. B. rechteckförmige Metallisierungselektrode zum Anschliessen nicht gezeichneter Drahtverbindungen. Die Metallisierungselektrode 19b der Drain-Halbleiterzone 9 ist mit der

$V_{DD}$-Speiseleitung 20b (Fig. 7) und diejenige 19a der Source-Halbleiterzone 7 mit der $V_{SS}$-Speiseleitung 20a des MOS-Hallelementes verbunden. In Fig. 7 ist $V_{DD}$ der positive und $V_{SS}$ der negative Pol der das MOS-Hallelement speisenden Spannungsquelle 4.

Das Substrat 5 besteht aus $N^-$, die Wanne 6 aus $P^-$ und die Halbleiterschichten 7, 8 und 9 aus $N^+$-Material, wobei $N^+$-Material stark dotiertes N-Material ist.

Trotz der hohen Trägerkonzentration, d. h. niedrigen Resistivität $\rho$, der zentralen Halbleiterzone 8 besitzt diese bedingt durch ihre Länge I und ihren Querschnitt S eine endliche Leitfähigkeit und damit einen von Null verschiedenen elektrischen Widerstand $R = \rho I/S$. Dieser ist über die ganze Länge der Halbleiterschicht 8, d. h. über die gesamte Breite W der MOS-Transistoren 10 und 11 annähernd gleichmässig verteilt. Im zugehörigen elektrischen Ersatzschaltbild Fig. 7 des MOS-Hallelementes gemäss der Fig. 5 und der Fig. 6 ist dieser uniform verteilte Widerstand durch eine Reihenschaltung einer grossen Anzahl von elektrischen Widerständen schematisch dargestellt. Aus zeichnerischen Gründen wurden nur sechs Widerstande R1 bis R6 gezeichnet. Auch die aus Polysilizium hergestellten Gate-Elektrodenschichten 14 und 15 besitzen eine endliche Leitfähigkeit und sind daher in der Fig. 7 ebenfalls je durch eine Reihenschaltung elektrischer Widerstände R7 bis R12 bzw. R13 bis R18 dargestellt. Die bereits erwähnte Reihenschaltung der beiden MOS-Transistoren 10 und 11 besteht, wie aus der Fig. 7 ersichtlich, im Grunde genommen aus einer grossen Anzahl parallelgeschalteter Reihenschaltungen eines ersten und eines zweiten MOS-Teiltransistors, wie z. B. diejenige des ersten MOS-Teiltransistors 21 und des zweiten MOS-Teiltransistors 22. Alle zentralen Halbleiterzonen dieser Teiltransistorpaare, alle Gate-Elektrodenschichten der ersten Teiltransistoren und alle Gate-Elektrodenschichten der zweiten Teiltransistoren sind jeweils unter sich durch einen oder mehrere Widerstände R1 bis R6, R7 bis R12 oder R13 bis R18 miteinander verbunden. Sind die Werte dieser Widerstände gross genug, so sind diese Zonen und Elektrodenschichten in erster Annäherung elektrisch voneinander getrennt und die Teiltransistorpaare nur mittels der Speiseleitungen 20a und 20b miteinander verbunden, d. h. parallelgeschaltet. Die Substrate aller Teiltransistoren sind elektrisch direkt miteinander und mit der $V_{SS}$-Speiseleitung 20a verbunden.

Die Widerstände R1 bis R6 der zentralen Halbleiterzone 8 verhindern das in der Darstellung der Zeichnung horizontale Fliessen von Querströmen senkrecht zur Stromflussrichtung der beiden MOS-Transistoren 10 und 11. Die zentrale Halbleiterzone 8 und die Inversionsschicht K des zweiten MOS-Transistors 11 bilden zusammen das eigentliche Hallelement 1, während der erste MOS-Transistor 10, der im Sättigungsbereich betrieben wird, die Funktion der ersten Stromquelle 2' übernimmt.

Die zweite Stromquelle 2" ist in den Darstellungen der Fig. 5, der Fig. 6 und der Fig. 7 nur teilweise vorhanden durch das Vorhandensein des Sättigungswiderstandes des zweiten MOS-Transistors 11. Um ihr Vorhandensein vollständig zu gewährleisten, muss die Metallisierungselektrode 19b des zweiten MOS-Transistors 11 weggelassen werden und die Drain-Halbleiterschicht 9 durch eine Vielzahl von nicht dargestellten MOS-Transistoren gespeist werden, ähnlich wie bei der später beschriebenen vierten Variante.

Die beiden Enden der zentralen Halbleiterzone 8, d. h. die Anschlussfahnen 16a und 16b, bilden zusammen den zweipoligen Hallausgang C, D des MOS-Hallelementes. Die erste Steuerspannung $V'_g$ (Fig. 7) liegt an einer der beiden Anschlussfahnen 18a oder 18b der Gate-Elektrodenschicht 15 des zweiten MOS-Transistors 11, z. B. an 18a. Eine erste Referenzspannung $V_{Ref1}$ ist auf die Anschlussfahne 17a und eine zweite Referenzspannung $V_{Ref2}$ auf die Anschlussfahne 17b der Gate-Elektrodenschicht 14 des ersten Transistors 10 geführt. Die beiden Referenzspannungen $V_{Ref1}$ und $V_{Ref2}$ dienen dazu, die Offset-Spannung des MOS-Hallelementes auf Null einzustellen, da eine Erhöhung z. B. von $V_{Ref2}$ eine Erniedrigung der Spannung an der Anschlussfahne 16b, d. h. an dem Pol D des Hallausganges C, D des MOS-Hallelementes bewirkt. Sie kann somit dazu dienen, die Ausgangsspannung des MOS-Hallelementes genau auf Null einzustellen, wenn das Eingangssignal des MOS-Hallelementes Null ist. Dieses Eingangssignal ist gleich dem Produkt I.H, wobei wie bereits erwähnt H den Wert des Magnetfeldes 3 und I den Wert des Speisestroms des Hallelementes darstellt.

Die Widerstände R13 bis R18 sind an sich bedeutungslos, da die Gate-Elektrodenschicht 15 nur einseitig von der Anschlussfahne 18a her gespeist wird und praktisch keine elektrischen Ströme fliessen. Die Gate-Elektrodenschicht 15 könnte daher, im Gegensatz zur Gate-Elektrodenschicht 14, sogar aus einem Metall, z. B. aus Aluminium, bestehen.

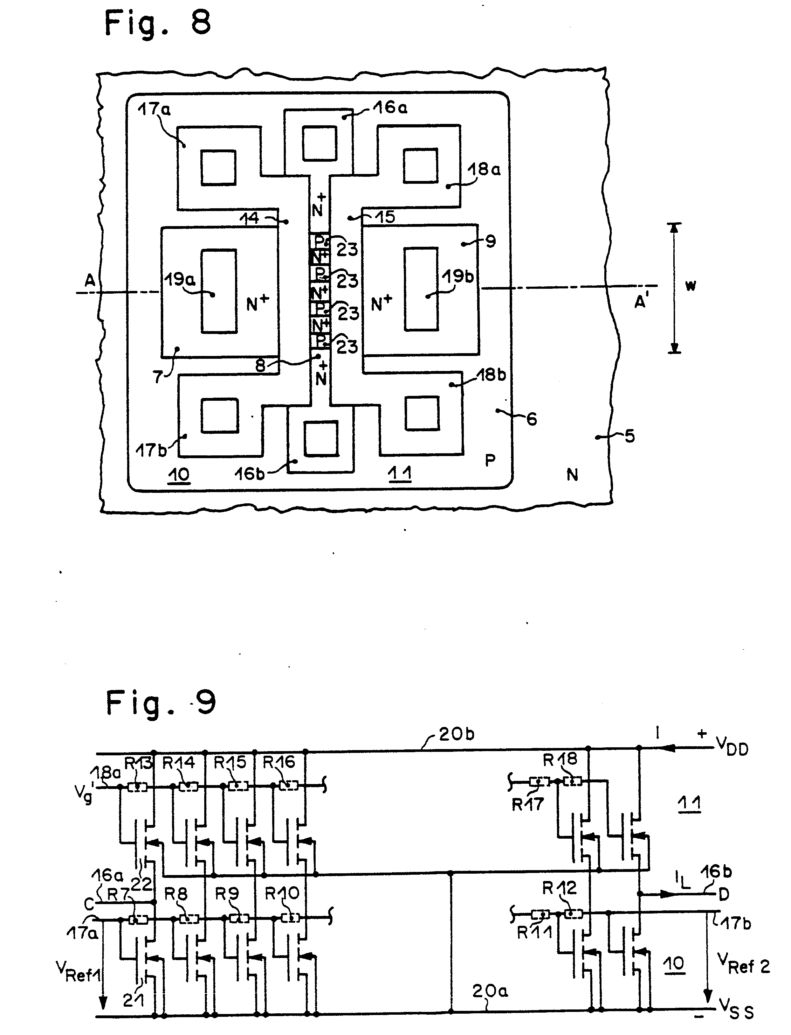

In der Fig. 8 ist die Draufsicht einer zweiten Variante eines MOS-Hallelementes mit Stromspeisungsanordnung dargestellt. Ihr Querschnitt AA' ist identisch mit demjenigen, der in der Fig. 5 wiedergegeben ist, und ihr elektrisches Ersatzschaltbild findet sich in der Fig. 9.

Die Fig. 8 unterscheidet sich von der Fig. 6 nur dadurch, dass die dotierte zentrale Halbleiterzone 8 über die gesamte Breite W der Transistoren 10 und 11 in annähernd regelmässigen Abständen durchsetzt ist von einer Vielzahl elektrisch nicht leitender Halbleiterbereiche 23 aus P-Material. Diese nicht leitenden Halbleiterbereiche 23 besitzen mindestens die Tiefe und die Breite der zentralen Halbleiterzone 8. Ihre Ausdehnung in Richtung der Transistorbreite W ist beliebig, jedoch verschieden von Null, und ihre Querschnitte sind alle annähernd rechteckförmig. Die Existenz dieser nicht leitenden Halbleiterbereiche 23 hat zur Folge, dass die Widerstände R1 bis R6 der zentralen Halbleiterzone 8 der Fig. 7 einen Wert Unendlich annehmen und daher in der Darstellung der Fig. 9 nicht mehr vorkommen. Ansonsten unterscheidet sich die Fig. 9 in nichts von der Fig. 7. Die einzelnen Teiltransistorpaare 21 ; 22 sind somit nicht nur praktisch, sondern auch ideal getrennt. Gleichzeitig belastet die Reihenschaltung der Widerstände R1 bis R6 nicht mehr den Hallausgang C, D des MOS-Hallelementes mit einem Leckstrom, so dass der zum externen Ausgangsstrom des MOS-Hallelementes parallele Leckstrom in diesen Widerständen vermieden wird. Dies bringt noch eine weitere zusätzliche Verbesserung der Empfindlichkeit des MOS-Hallelementes.

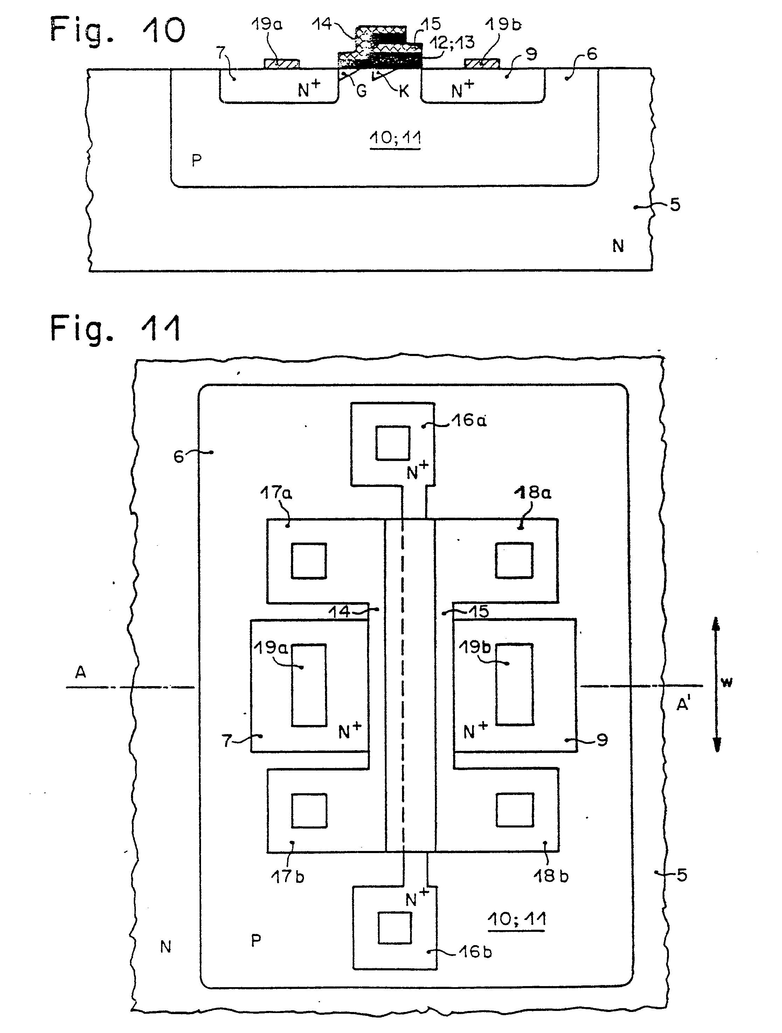

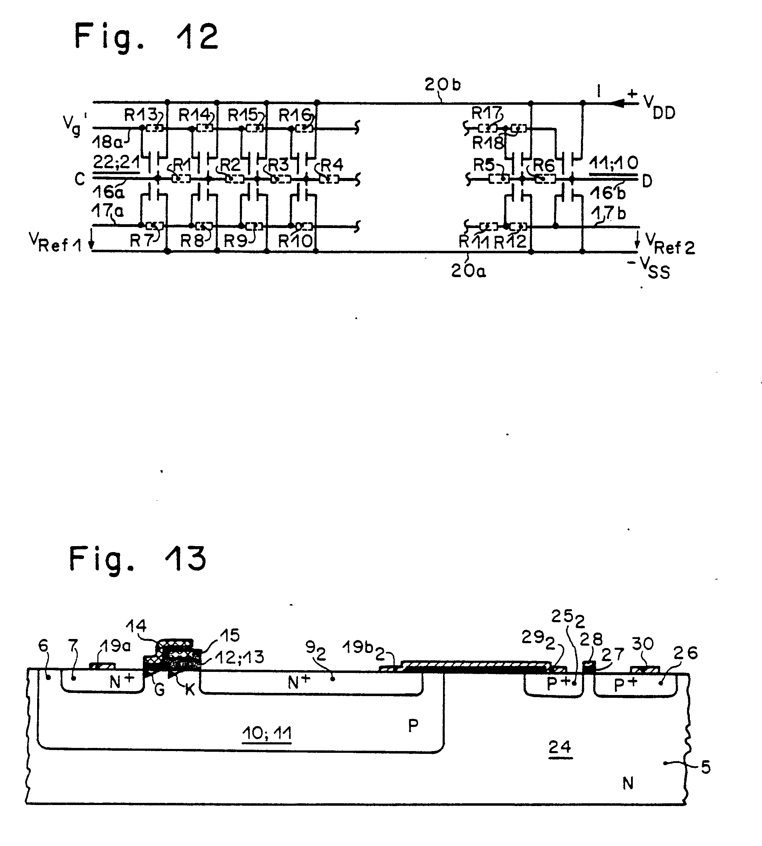

In der Fig. 10 und in der Fig. 11 sind Ansichten einer dritten Variante eines MOS-Hallelementes mit Stromspeisungsanordnung dargestellt. Ihr elektrisches Schaltbild ist in der Fig. 12 wiedergegeben.

Der Querschnitt AA' dieses MOS-Hallelementes gemäss der Fig. 10 entspricht dem Querschnitt AA' gemäss der Fig. 5, nur dass die Breite der zentralen Halbleiterzone 8 hier auf Null reduziert wurde und die Gate-Elektrodenschicht 14 des ersten MOS-Transistors 10 die Gate-Elektrodenschicht 15 des zweiten MOS-Transistors 11 überlappt. Die beiden $SiO_2$-Schichten 12 und 13 sind zu einer einzigen $SiO_2$-Schicht 12, 13 zusammengefasst und dermassen räumlich ausgebildet, dass sie zusätzlich noch zu ihrer Funktion als Gate-Oxyd der beiden MOS-Transistoren 10 und 11 gemäss der Fig. 5 die Gate-Elektrodenschichten 14 und 15 räumlich voneinander trennen. Durch den Wegfall der zentralen Halbleiterzone 8 bilden die beiden Transistoren 10 und 11 allerdings nur mehr einen einzigen MOS-Transistor 10, 11. Dieser einzige MOS-Transistor besitzt somit ein doppeltes Gate 14 und 15, so dass in seinem Kanal zwischen der Source- und der Drain-Halbleiterzone 7 und 9 die Inversionsschicht G des ersten MOS-Transistors 10 als erste und die Inversionsschicht K des zweiten MOS-Transistors 11 als zweite Inversionsschicht vorhanden sind, die räumlich identisch angeordnet sind wie die Inversionsschicht G und K in der Fig. 5.

Auch die Fig. 11 entspricht praktisch der Fig. 6, nur dass hier ebenfalls die zentrale Halbleiterzone 8 fehlt und die beiden Gate-Elektrodenschichten 14 und 15 überlappend sind. Die Anschlussfahnen 16a und 16b sind hier natürlich keine Anschlussfahnen der nicht vorhandenen zentralen Halbleiterzone 8, sondern sind eigene Diffusionen aus stark mit Verunreinigungen dotiertem N-Material, d. h. aus $N^+$-Material, die je an einem Ende, quer zur Stromflussrichtung der MOS-Transistoren 10 und 11 betrachtet, der zweiten Inversionsschicht K in der Wanne 6 eindiffundiert und mit dem jeweiligen Ende der zweiten Inversionsschicht elektrisch leitend verbunden sind.

Die Fig. 12 ist annähernd gleich der Fig. 7, nur dass jedes Paar der Teiltransistoren 22 und 21 zu einem einzigen Teiltransistor 22, 21 zusammengefasst ist. Die Widerstände R1 bis R6 stellen hier die Teilwiderstände der zweiten Inversionsschicht K dar, die die zweiten Inversionsschichten der einzelnen Teiltransistoren 22, 21 miteinander verbinden. In der Fig. 12 wurden zugunsten der Uebersichtlichkeit der Zeichnung die Substrate der einzelnen Teiltransistoren mit ihren jeweiligen Verbindungen nicht dargestellt. Sie sind natürlich genauso vorhanden und verbunden wie in der Fig. 7 angegeben.

Die Funktion der Schaltung gemäss der Fig. 12 ist identisch mit derjenigen der Schaltung gemäss der Fig. 7, wie leicht an Hand der Aehnlichkeit der beiden Schaltbilder ersichtlich ist.

Alle drei bisher beschriebenen Varianten haben den Nachteil, dass die zweite Stromquelle 2″ weiterhin nicht vollständig aus der gewünschten Vielzahl von Teilstromquellen besteht, sondern dass dies nur bei der ersten Stromquelle 2′ der Fall ist. Insofern stellen alle drei Varianten zwar eine Verbesserung gegenüber dem Stand der Technik dar, sind jedoch noch weiter verbesserungsfähig im Sinne einer Ideallösung gemäss der Fig. 4. Eine nachfolgende vierte Variante ersetzt in der dritten Variante die nicht dargestellte zweite Stromquelle 2″ durch eine Vielzahl diskreter Teilstromquellen. Der in dieser vierten Variante für die dritte Variante beschriebene Lösungsweg kann auch sinngemäss für die erste und die zweite Variante verwendet werden.

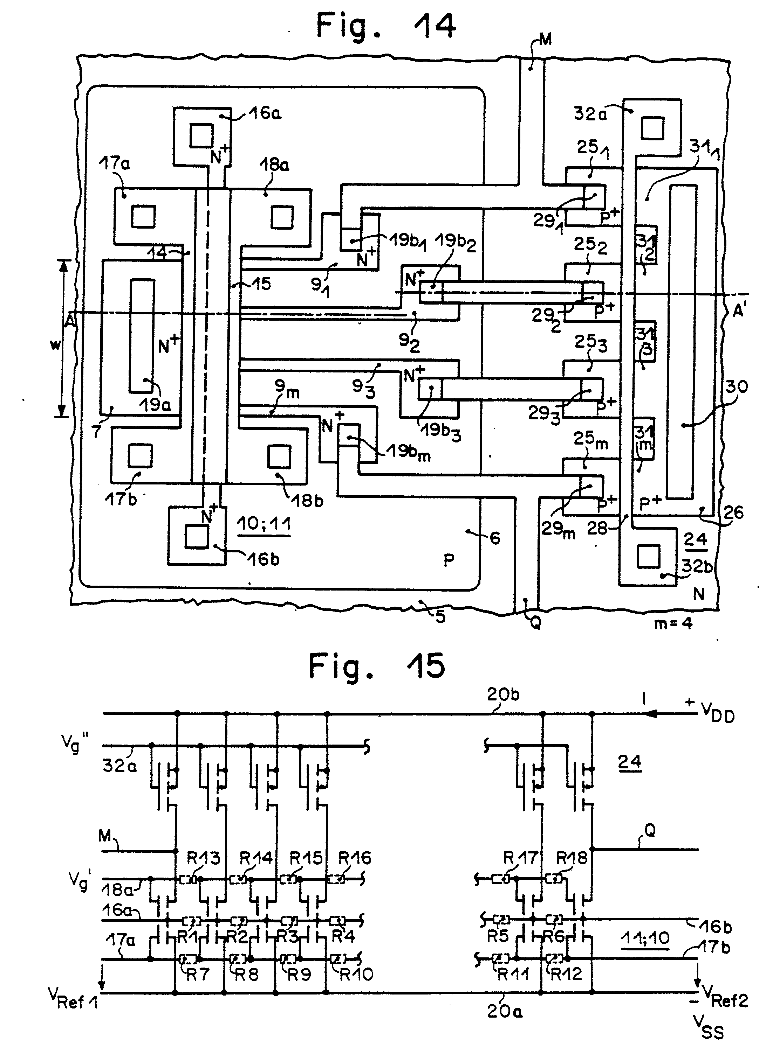

In der Fig. 13 und in der Fig. 14 sind Ansichten der vierten Variante eines MOS-Hallelementes mit Stromspeisungsanordnung dargestellt. Ihr elektrisches Schaltbild ist in der Fig. 15 wiedergegeben. Die Drain-Halbleiterzone 9 besteht bei dieser vierten Variante, die wie bereits erwähnt, eine Weiterentwicklung der dritten Variante ist, aus einer Vielzahl von m fahnenförmigen, voneinander getrennten Drain-Halbleiterteilzonen $9_1$ ; $9_2$ ; ... ; $9_m$, die je eine eigene Metallisierungselektrode $19b_1$ ; $19b_2$ ; ... ; $19b_m$ besitzen. Das so abgeänderte MOS-Hallelement ist in der Darstellung der Fig. 13 und der Fig. 14 links und in der Darstellung der Fig. 15 unten wiedergegeben. Neu ist ein dritter MOS-Transistor 24 vorhanden, z. B. ein PMOS-Transistor, der m getrennte Drain-Halbleiterzonen $25_1$ ; $25_2$ ; ... ; $25_m$, eine einzige Source-Halbleiterzone 26, eine einzige $SiO_2$-Schicht 27 und eine einzige Gate-Elektrodenschicht 28 besitzt, und der in den Darstellungen der Fig. 13, der Fig. 14 und der Fig. 15 rechts bzw. oben wiedergegeben ist. Die Drain- und die Source-Halbleiterzonen $25_1$ bis $25_m$ und 26 des dritten MOS-Transistors 24 bestehen aus $P^+$-Material, d. h. aus stark dotiertem P-Material, und sind in dem Substrat 5 eindiffundiert. Die Gate-Schicht 28 besteht ihrerseits aus Polysilizium oder wie in der Zeichnung angenommen aus Metall, z. B. aus Aluminium. Jede der m Drain-Halbleiterzonen $25_1$, bis $25_m$ des dritten MOS-Transistors 24 besitzt eine Metallisierungselektrode $29_1$ ; $29_2$ ; ... ; $29_m$, deren jede mit einer Metallisierungselektrode $19b_1$ ; $19b_2$ ; ... ; $19b_m$ des abgeänderten MOS-Hallelementes über eine Metallisierungsverbindung verbunden ist. Die Source-Halbleiterzone 26 besitzt eine Metallisierungselektrode 30 und gegenüberliegend zu jeder

Drain-Halbleiterzone $25_1$ ; $25_2$ ; ... ; $25_m$ ein balkonartig vorstehendes rechteckförmiges Schichtteil $31_1$ ; $31_2$ ; ... ; $31_m$, so dass der dritte MOS-Transistor 24 praktisch aus m parallelen MOS-Teiltransistoren besteht mit m getrennten Drains, einer gemeinsamen Source und m miteinander verbundenen Gates. In der vierten Variante liegt die Metallisierungselektrode 30 und nicht mehr die Metallisierungselektrode 19b an der $V_{DD}$-Speiseleitung 20b. Die Gate-Elektrodenschicht 28 reicht über alle Kanäle des dritten MOS-Transistors 24 hinweg und besitzt an ihren beiden Enden, quer zur Stromflussrichtung der Transistoren betrachtet, je eine Anschlussfahne 32a bzw. 32b, wovon eine, z. B. 32a, zum Anlegen einer zweiten Steuerspannung $V''_g$ benutzt wird. Die Kanten der Gate-Elektrodenschicht 28 und der $SiO_2$-Schicht 27 des dritten MOS-Transistors 24 sind untereinander und mit der jeweils angrenzenden Kante der Drain-Halbleiterzonen $25_1$ ; $25_2$ ; ... ; $25_m$ bzw. der Schichtteile $31_1$ ; $31_2$ ; ... ; $31_m$ der Source-Halbleiterzone 26 bündig.

Die Metallisierungsverbindung zwischen der ersten Drain-Halbleiterzone $9_1$ des zweiten MOS-Transistors 11 und der ersten Drain-Halbleiterzone $25_1$ des dritten MOS-Transistors 24 besitzt einen Anschluss nach aussen, der den ersten Pol M (Fig. 15) eines ersten zweipoligen Hallausganges M, Q des Hallelementes bildet. Desgleichen besitzt diejenige zwischen der letzten Drain-Halbleiterzone $9_m$ des zweiten MOS-Transistors 11 und der letzten Drain-Halbleiterzone $25_m$ des dritten MOS-Transistors 24 einen Anschluss nach aussen, der den zweiten Pol Q des ersten zweipoligen Hallausganges M, Q des Hallelementes bildet.

In der Fig. 14 ist aus zeichnerischen Gründen m = 4 gewählt worden. In der Praxis ist m jedoch möglichst gross zu wählen.

Wie aus der Fig. 15 ersichtlich, wird nun jeder Teiltransistor des Hallelementes gemäss der dritten Variante auch von der $V_{DD}$-Speiseleitung 20b aus über je einen Teiltransistor des dritten MOS-Transistors 24 gespeist, die alle als Teilstromquellen arbeiten, wenn sie alle jeweils in ihrem Sättigungsgebiet betrieben werden. Unter der Voraussetzung, dass m sehr gross gewählt ist, entspricht Fig. 15 funktionell vollständig der Fig. 4. Das MOS-Hallelement gemäss der Fig. 15 besitzt allerdings nicht einen einzigen zweipoligen, sondern zwei zweipolige Hallausgänge M, Q und 16a, 16b an denen die Hallspannungen $V_{Out1}$ und $V_{Out2}$ anstehen und die unterschiedliche Ausgangswiderstände besitzen. Die zweite Steuerspannung $V''_g$ ist so zu wählen, dass die Teiltransistoren des dritten MOS-Transistors 24 als Stromquellen arbeiten, d. h. im Sättigungsgebiet betrieben werden.

In der Variante 3 (Fig. 10) und in der Variante 4 (Fig. 13) können die beiden Gate-Elektrodenschichten 14 und 15 auch nichtüberlappend, parallel und isoliert voneinander, z. B. mittels $SiO_2$, in einer einzigen Ebene angeordnet sein, unter der Bedingung, dass der Abstand zwischen den beiden Gate-Elektrodenschichten 14 und

15 ≤ 1 μm ist.

Die bisher beschriebenen Hallelemente können als Magnetfeldsensoren in Strom-Messwandlern am Eingang von Elektrizitätszählern eingesetzt werden zum Messen des verbrauchten elektrischen Stromes. Dieser Strom-Messwert dient dann anschliessend in Zusammenhang mit einem Spannungs-Messwert zur Ermittlung der verbrauchten elektrischen Energie.

Es gibt grundsätzlich zwei Varianten A und B, solche Elektrizitätszähler elektronisch zu realisieren.

Die Variante A ist in der DE-OS 29 48 762 (= GB-OS 20 64 140) beschrieben. In dieser Variante A wird das vom verbrauchten und zu messenden Strom erzeugte Magnetfeld mit Hilfe eines Referenz-Magnetfeldes abgetastet und die Nullwerte der Differenz beider Magnetfelder elektronisch ausgewertet. Das Referenz-Magnetfeld ist z. B. sägezahnförmig und wird z. B. mittels eines Referenzstromes erzeugt. Der Referenzstrom und der verbrauchte zu messende Strom durchfliessen je einen Flachleiter, der in der Nähe der Oberfläche des Magnetfeldsensors angeordnet ist. Der Flachleiter kann auch U-förmig gebogen sein und den in einem Gehause montierten Magnetfeldsensor U-förmig umgeben.

Die Variante B ist in der DE-OS 31 33 908 (= US-Anmeldenummer 06/332.215) beschrieben. In dieser Variante B wird das vom verbrauchten und zu messenden Strom erzeugte Magnetfelt mit Hilfe eines Kompensationsmagnetfeldes kompensiert und ein dieses Kompensationsmagnetfeld erzeugender Kompensationsstrom, der von einem Regelkreis geliefert wird, anschliessend elektronisch ausgewertet. Zur Erzeugung der zugehörigen Magnetfelder durchfliessen der zu messende Strom und der Kompensationsstrom je einen Flachleiter, der in der Nähe der Oberfläche des Magnetfeldsensors angeordnet ist. In einer bevorzugten Anordnung sind auch hier die Flachleiter U-förmig gebogen und umgeben den in einem Gehäuse montierten Magnetfeldsensor U-förmig.

In allen Varianten sind die benötigten elektronischen Schaltungen vorzugsweise in dem gleichen Substrat integriert, in das auch der Magnetfeldsensor integriert ist, so dass im Idealfall nur eine einzige gemeinsame integrierte Schaltung vorhanden ist.

Zwecks Verdichtung der Magnetfelder wird das den Magnetfeldsensor enthaltene Substrat in bevorzugten Anordnungen im oder in der unmittelbaren Nähe vom Luftspalt eines Magnetkernes mit seiner Oberfläche senkrecht zu den Magnetfeldern angeordnet, z. B. gemäss einer der in der DE-OS 29 18 483 (= US-PS 43 62 990) beschriebenen Montagemethoden. In diesen Fällen genügt es, ein dort verwendetes Substrat mit darauf montiertem Magnetfilm durch den Magnetfeldsensor zu ersetzen.

Bisher wurde angenommen, dass der gesamte verbrauchte Strom im Magnetfeldsensor gemessen wird. Ist dieser Strom jedoch sehr gross, genügt es, einen konstanten und bekannten Bruchteil dieses Stromes dem Magnetfeldsensor in Form eines Magnetfeldes zuzuführen.

Dies geschieht nach einer der drei nachfolgenden Methoden :

Bei einer ersten, unter anderem in der DE-PS 30 08 308 (= GB-PS 20 50 070) beschriebenen Methode mit Stromteiler wird ein Teil des zu messenden Stromes mit Hilfe eines Shunts vom Magnetfeldsensor ferngehalten.

Bei einer zweiten, in der US-PS 42 40 059 beschriebenen Brücken-Methode, wird der zu messende Strom einer Messbrücke dermassen zugeführt, dass nur der im Diagonalzweig der Messbrücke fliessende Teil des zu messenden Stromes den Magnetfeldsensor erreicht und von diesem ausgewertet wird.

Eine dritte, in der Internationalen Patentanmeldung WO 83/01 535 beschriebene Methode sieht vor, den zu messenden Strom einem Stromwandler zuzuführen, dessen Primärwicklung aus zwei gegensinnig von Strömen durchflossenen und annähernd gleiche Widerstände aufweisenden Leitern besteht.

**Patentansprüche**

1. Hallelement mit einer Stromspeisunganordnung aus einer ersten Stromquelle (2') und aus einer zweiten Stromquelle (2''), die beide elektrisch in Reihe geschaltet sind und von denen mindestens eine aus einer Vielzahl von Teilstromquellen besteht, die ihrerseits je das Hallelement (1) parallel zueinander, jedoch an verschiedenen Orten je einer seiner zwei gegenüberliegenden Breitseiten speisen, dadurch gekennzeichnet, dass die Teilstromquellen diskret oder kontinuierlich über die ganze Breite (W) des Hallelements (1) verteilt sind, dass alle Teilstromquellen von einer gemeinsamen Spannungsquelle (4) gespeist sind, die über die hochohmigen Innenwiderstände der Teilstromquellen mit dem Hallelement in Verbindung steht, und dass jede Teilstromquelle (2' ; 2'') mindestens aus der Source- und Kanalzone eines MOS-Transistor besteht.

2. Hallelement nach Anspruch 1, dadurch gekennzeichnet, dass die erste Stromquelle (2') aus einem ersten MOS-Transistor (10) mit einer ersten Inversionsschicht (G) und das Hallelement (1) aus einem zweiten MOS-Transistor (11) mit einer zweiten Inversionsschicht (K) besteht, dass beide MOS-Transistoren (10 ; 11) eine gemeinsame dotierte zentrale Halbleiterzone (8) besitzen, so dass beide MOS-Transistoren (10 ; 11) elektrisch in Reihe geschaltet sind, dass die dotierte zentrale Halbleiterzone (8) und die Gate-Elektrodenschicht (14) des ersten MOS-Transistors (10) jeweils an ihren beiden äusseren, quer zur Stromflussrichtung der beiden MOS-Transistoren (10 ; 11) betrachteten Ende je eine Anschlussfahne (16a ; 16b bzw. 17a ; 17b) besitzen, wobei die Anschlussfahnen (16a ; 16b) der dotierten, zentralen Halbleiterzone (8) den zweipoligen Ausgang des Hallelementes (1) und diejenigen (17a ; 17b) der Gate-Elektrodenschicht (14) des ersten MOS-Transistors (10) zwei Eingänge zum Einstellen der Offset-Spannung des Hallelementes (1) bilden und dass die Gate-Elektrodenschicht (14) des ersten MOS-Transistors (10) aus Material mit endlicher Leitfähigkeit besteht.

3. Hallelement nach Anspruch 2, dadurch gekennzeichnet, dass über die gesamte Breite (W) der MOS-Transistoren (10 ; 11) in die dotierte, zentrale Halbleiterzone (8) in annähernd regelmässigen Abständen durchsetzt ist von einer Vielzahl elektrisch nicht leitender Halbleiterbereiche (23) mit Tiefen und Breiten, die mindestens gleich sind denjenigen der dotierten, zentralen Halbleiterzone (8).

4. Hallelement nach Anspruch 2, dadurch gekennzeichnet, dass die Breite der dotierten, zentralen Halbleiterzone (8) Null ist, dass die Gate-Elektrodenschicht (14) des ersten MOS-Transistors (10) die Gate-Elektrodenschicht (15) des zweiten MOS-Transistors (11) überlappt oder in einer Ebene und parallel zueinander mit einem Abstand $\leq 1 \mu m$ angeordnet sind, dass die beiden $SiO_2$-Schichten (12 ; 13) der MOS-Transistoren (10 ; 11) eine einzige $SiO_2$-Schicht bilden, die dermassen ausgebildet ist, dass sie zusätzlich zu ihrer Funktion als Gate-Oxyd für die beiden MOS-Transistoren (10 ; 11) noch die beiden Gate-Elektrodenschichten (14 ; 15) der beiden MOS-Transistoren unter sich räumlich voneinander trennt, und dass quer zur Stromflussrichtung der MOS-Transistoren (10 ; 11) betrachtet, an den beiden äusseren Enden der zweiten Inversionsschicht (K) als Anschlussfahnen (16a ; 16b) je eine Diffusionszone aus stark mit Verunreinigungen dotiertem Material vorhanden ist, die jede mit dem jeweiligen Ende der zweiten Inversionsschicht (K) elektrisch leitend verbunden ist.

5. Hallelement nach einem der Ansprüche 2 bis 4, dadurch gekennzeichnet, dass der zweite MOS-Transistor (11) eine Vielzahl fahnenförmiger, voneinander getrennter Drain-Halbleiterzonen ($9_1$ ; $9_2$ ; ... ; $9_m$) besitzt, die über je eine Metallisierungsverbindung mit je einer Drain-Halbleiterzone ($25_1$ ; $25_2$ ; ... ; $25_m$) eines dritten MOS-Transistors (24) verbunden sind, dessen einzige Source-Halbleiterzone (26) für jede seiner Drain-Halbleiterzone ($25_1$ ; $25_2$ ; ... ; $25_m$) und diesen gegenüberliegend ein balkonartig vorstehendes rechteckförmiges Zonenteil ($31_1$ ; $31_2$ ; ... ; $31_m$) besitzt und dessen einzige Gate-Elektrodenschicht (28) an mindestens einem seiner quer zur Stromflussrichtung der MOS-Transistoren betrachteten Enden eine Anschlussfahne (32a) besitzt, wobei die Metallisierungsverbindung zwischen der ersten Drain-Halbleiterzone ($9_1$) des zweiten MOS-Transistors (1) und der ersten Drain-Halbleiterzone ($25_1$) des dritten MOS-Transistors (24) einen ersten Pol (M) eines zweipoligen Ausganges und diejenige zwischen der letzten Drain-Halbleiterzone ($9_m$) des zweiten Transistors (11) und der letzten Drain-Halbleiterzone ($25_m$) des dritten MOS-Transistors (24) einen zweiten Pol (Q) des zweipoligen Ausganges des Hallelementes bildet.

6. Hallelement nach einem der Ansprüche 1 bis 5, dadurch gekennzeichnet, dass es ein Teil eines Elektrizitätszählers ist.

7. Hallelement nach Anspruch 6, dadurch gekennzeichnet, dass das vom verbrauchten und zu messenden Strom erzeugte Magnetfeld mit Hilfe eines Referenz-Magnetfeldes abgetastet ist und Nullwerte der Differenz beider Magnetfelder ausgewertet sind.

8. Hallelement nach Anspruch 6, dadurch gekennzeichnet, dass das vom verbrauchten und zu messenden Strom erzeugte Magnetfeld mit Hilfe eines Kompensationsmagnetfeldes kompensiert und ein dieses Kompensationsmagnetfeld liefernder Kompensationsstrom anschliessend ausgewertet ist.

9. Hallelement nach Anspruch 7 oder 8, dadurch gekennzeichnet, dass alle Magnetfelder mittels Strömen erzeugt sind, die Flachleiter durchfliessen, die in der Nähe der Oberfläche des als Magnetfeldsensor dienenden Hallelements angeordnet sind.

10. Hallelement nach Anspruch 9, dadurch gekennzeichnet, dass die Flachleiter U-förmig gebogen sind und den in einem Gehäuse montierten Magnetfeldsensor U-förmig umgeben.

11. Hallelement nach einem der Ansprüche 7 bis 10, dadurch gekennzeichnet, dass alle benötigten elektronischen Schaltungen in dem gleichen Substrat integriert sind, in das auch das Hallelement integriert ist.

12. Hallelement nach einem der Ansprüche 7 bis 11, dadurch gekennzeichnet, dass das das Hallelement enthaltende Substrat im oder in der unmittelbaren Nähe vom Luftspalt eines Magnetkerns mit seiner Oberfläche senkrecht zu den Magnetfeldern angeordnet ist.

13. Hallelement nach einem der Ansprüche 7 bis 12, dadurch gekennzeichnet, dass der zu messende Strom einem Stromteiler zugeführt ist, so dass ein Teil des zu messenden Stromes mit Hilfe eines Shunts vom Hallelement ferngehalten ist.

14. Hallelement nach einem der Ansprüche 7 bis 12, dadurch gekennzeichnet, dass der zu messende Strom einer Messbrücke dermassen zugeführt ist, dass nur der im Diagonalzweig der Messbrücke fliessende Teil des zu messenden Stromes das Hallelement erreicht.

15. Hallelement nach einem der Ansprüche 7 bis 12, dadurch gekennzeichnet, dass der zu messende Strom einem Stromwandler zugeführt ist, dessen Primärwicklung aus zwei gegensinnig von Strömen durchflossenen und annähernd gleiche Widerstände aufweisenden Leitern besteht.

**Claims**

1. A Hall element having a current feed arrangement comprising a first current source (2') and a second current source (2") which are both electrically connected in series and one at least of which comprises a plurality of current source portions which in turn respectively feed the Hall element (1) in parallel with each other but at different locations of a respective one of its two oppositely disposed wide sides characterised in that the current source portions are discretely or continuously distributed over the entire width (W) of the Hall element (1), that all current source portions are fed by a common voltage source (4) which is connected to the Hall element by way of the high internal resistances of the current source portions and that each current source portion (2' ; 2") comprises at least the source and channel regions of an MOS-transistor.

2. A Hall element according to claim 1 characterised in that the first current source (2') comprises a first MOS-transistor (10) having a first inversion layer (G) and the Hall element (1) comprises a second MOS-transistor (11) having a second inversion layer (K), that both MOS-transistors (10 ; 11) have a common doped central semiconductor region (8) so that both MOS-transistors (10 ; 11) are electrically connected in series, that the doped central semiconductor region (8) and the gate electrode layer (14) of the first MOS-transistor (10) each have a respective terminal lug (16a ; 16b or 17a ; 17b) at their two outer ends considered transversely with respect to the direction of current flow in the two MOS-transistors (10 ; 11), wherein the terminal lugs (16a ; 16b) of the doped central semiconductor region (8) form the two-pole output of the Hall element (1) and the terminal lugs (17a ; 17b) of the gate electrode layer (14) of the first MOS-transistor (10) form two inputs for adjustment of the offset voltage of the Hall element (1) and that the gate electrode layer (14) of the first MOS-transistor (10) comprises material of finite conductivity.

3. A Hall element according to claim 2 characterised in that over the entire width (W) of the MOS-transistors (10 ; 11), a multiplicity of electrically non-conductive semiconductor regions (23) passes through the doped central semiconductor region (8) at approximately uniform spacings, the electrically non-conductive semiconductor regions (23) being of depths and widths which are at least equal to those of the doped central semiconductor region (8).

4. A Hall element according to claim 2 characterised in that the width of the doped central semiconductor region (8) is zero, that the gate electrode layer (14) of the first MOS-transistor (10) overlaps the gate electrode layer (15) of the second MOS-transistor (11) or they are arranged in one plane and parallel to each other at a spacing $\leq 1$ $\mu$m, that the two $SiO_2$-layers (12 ; 13) of the MOS-transistors (10 ; 11) form a single $SiO_2$-layer which is such that in addition to its function as gate oxide for the two MOS-transistors (10 ; 11) it also provides for separation in space of the two gate electrode layers (14 ; 15) of the two MOS-transistors from each other, and that, as considered transversely with respect to the direction of current flow in the MOS-transistors (10 ; 11), provided at each of the two outer ends of the second inversion layer (K), as terminal lugs (16a ; 16b) is a respective diffusion zone comprising material which is heavily doped with impurities and each of which is electrically conductively connected to the respective end of the second inversion layer (K).

5. A Hall element according to one of claims 2 to 4 characterised in that the second MOS-transistor (11) has a multiplicity of lug-shaped mutually separated drain semiconductor regions ($9_1$ ; $9_2$ ; ... ; $9_m$) which are each connected by way of a respective metallisation connection to a respective drain semiconductor region ($25_1$ ; $25_2$ ; ... ; $25_m$) of a third MOS-transistor (24) whose single source semiconductor region (26), for each of its drain semiconductor regions ($25_1$ ; $25_2$ ; ... ; $25_m$) and in opposite relationship thereto, has a rectangular portion ($31_1$ ; $31_2$ ; ... ; $31_m$) projecting in a balcony-like configuration and whose single gate electrode layer (28) has a terminal lug (32a) at least one of its ends considered transversely with respect to the direction of current flow in the MOS-transistors, wherein the metallisation connection between the first drain semiconductor region ($9_1$) of the second MOS-transistor (11) and the first drain semiconductor region ($25_1$) of the third MOS-transistor (24) forms a first pole (M) of a two-pole output and the metallisation connection between the last drain semiconductor region ($9_m$) of the second transistor (11) and the last drain semiconductor region ($25_m$) of the third MOS-transistor (24) forms a second pole (Q) of the two-pole output of the Hall element.

6. A Hall element according to one of claims 1 to 5 characterised in that it is a part of an electricity meter.

7. A Hall element according to claim 6 characterised in that the magnetic field which is generated by the consumed current to be measured is scanned by means of a reference magnetic field and zero values in respect of the difference between the two magnetic fields are evaluated.

8. A Hall element according to claim 6 characterised in that the magnetic field generated by the consumed current to be measured is compensated by means of a compensation magnetic field and a compensation current supplying said compensation magnetic field is then evaluated.

9. A Hall element according to claim 7 or claim 8 characterised in that all magnetic fields are generated by means of currents which flow through flat conductors which are arranged in the vicinity of the surface of the Hall element which serves as a magnetic field sensor.

10. A Hall element according to claim 9 characterised in that the flat conductors are bent in a U-shape and are disposed in a U-shape around the magnetic field sensor which is mounted in a housing.

11. A Hall element according to one of claims 7 to 10 characterised in that all necessary electronic circuits are integrated in the same substrate as that in which the Hall element is also integrated.

12. A Hall element according to one of claims 7 to 11 characterised in that the substrate containing the Hall element is arranged in or in the direct vicinity of the air gap of a magnetic core with its surface perpendicular to the magnetic fields.

13. A Hall element according to one of claims 7 to 12 characterised in that the current to be measured is passed to a current divider so that a part of the current to be measured is kept away from the Hall element by means of a shunt.

14. A Hall element according to one of claims 7 to 12 characterised in that the current to be measured is fed to a measuring bridge in such a way that only the part of the current to be measured, which flows in the diagonal arm of the measuring bridge, reaches the Hall element.

15. A Hall element according to one of claims 7 to 12 characterised in that the current to be measured is passed to a current transformer whose primary winding comprises two conductors through which currents flow in opposite directions and which are of approximately equal resistances.

**Revendications**

1. Elément à effet Hall à dispositif d'alimentation de courant à partir d'une première source de courant (2') et d'une deuxième source de courant (2"), qui sont toutes deux branchées électriquement en série et dont une au moins se compose d'une multitude de sources de courant partiel, lesquelles de leur côté alimentent chacune l'élément à effet Hall (1) en parallèle, toutefois en différents endroits des deux côtés opposés les plus grands, caractérisé par le fait que, les sources de courant partiel sont réparties discrètement ou de façon continue sur toute la largeur (W) de l'élément à effet Hall (1), que toutes les sources de courant partiel sont alimentées par une source de tension commune (4), qui est en relation avec l'élément à effet Hall (1) par l'entremise des résistance internes de valeur ohmique élevée des sources de courant partiel, et que chaque source de courant partiel (2' ; 2") se compose au moins de la zone de source et de canal d'un transistor MOS.

2. Elément à effet Hall (1), selon la revendication 1, caractérisé en ce que la première source de courant (2') se compose d'un premier transistor MOS (10) avec une première couche d'inversion (G) et que l'élément à effet Hall (1) se compose d'un deuxième transistor MOS (11) avec une deuxième couche d'inversion (K), en ce que les deux transistors MOS (10 ; 11) possèdent une zone (8) centrale dopée commune de semiconducteur, de sorte que les deux transistors MOS (10 ; 11) sont branchés électriquement en série, que la zone (8) centrale dopée de semiconducteur et la couche d'électrode de grille (14) du premier transistor MOS (10) possèdent, respectivement à leurs deux extrémités externes considérées perpendiculairement au sens de passage du courant des deux transistors MOS (10 ; 11), une barrette (16a ; 16b ou 17a ; 17b), tout en remarquant que les barrettes (16a ; 16b) de la zone (8) centrale dopée de semi-conducteur constituent la sortie bi-polaire de l'élément à effet Hall (1), et celles (17a ; 17b) de la couche d'électrode de grille (14) du premier transistor MOS (10) constituent les deux entrées de réglage de la tension offset de l'élément à effet Hall (1) et que la couche d'électrode de grille (14) du premier transistor MOS (10) se compose d'une matière à conductibilité limitée.

3. Elément à effet Hall, selon la revendication 2, caractérisé en ce que sur toute la largeur (W) des transistors MOS (10 ; 11) il est chargé dans la zone (8) centrale dopée de semi-conducteur, à intervalles sensiblement réguliers, par une multitude de zones (23) de semi-conducteur électriquement non conductrices, avec des profondeurs et des largeurs, qui sont au moins égales à celles de la zone (8) centrale dopée de semi-conducteur.

4. Elément à effet Hall, selon la revendication 2, caractérisé en ce que la largeur de la zone (8) centrale dopée de semi-conducteur est nulle, en ce que la couche d'électrode de grille (14) du premier transistor MOS (10) recouvre la couche d'électrode de grille (15) du deuxième transistor MOS (11), ou bien elles sont disposées dans un même plan parallèlement l'une par rapport à l'autre avec un intervalle $\leq 1$ µm, en ce que les deux couches de $SiO_2$ (12 ; 13) des transistors MOS (10 ; 11) constituent une couche unique de $SiO_2$, qui est formée de façon que, en plus de sa fonction d'oxyde de grille pour les deux transistors MOS (10 ; 11), elle sépare encore physiquement l'une de l'autre les deux couches d'électrode de grille (14 ; 15) des deux transistors MOS, et que en considérant le sens perpendiculaire au passage du courant des transistors MOS (10 ; 11), aux deux extrémités extérieures de la deuxième couche d'inversion (K) comme barrettes (16a ; 16b) chacune dispose d'une zone de diffusion dans une matière fortement dopée par des impuretés, zone qui est reliée électriquement avec l'extrémité respective de la couche d'inversion (K).

5. Elément à effet Hall, selon l'une des revendications de 2 à 4, caractérisé en ce que le deuxième transistor MOS (11) possède une multitude de zones de semi-conducteur de drain ($9_1$ ; $9_2$ ; ... ; $9_m$) en forme de drapeau, séparées les unes des autres, qui sont reliées tantôt à une liaison par métallisation, tantôt à une zone de semi-conducteur de drain ($25_1$ ; $25_2$ ; ... ; $25_m$) d'un troisième transistor MOS (24), dont la seule zone de semi-conducteur de source (26), pour chacune de ses zones de semi-conducteur de drain ($25_1$ ; $25_2$ ; ... ; $25_m$) et se trouvant en face, possède une partie de zone rectangulaire disposée en saillie, à la façon d'un balcon ($31_1$ ; $31_2$ ; ... ; $31_m$), et dont la seule couche d'électrode de grille (28) possède, au moins à une de ses extrémités considérées perpendiculairement au sens de passage du courant des transistors MOS, une barrette (32a), dans laquelle la première zone de semi-conducteur de drain ($9_1$) du deuxième transistor MOS (11) (*) et la première zone de semi-conducteur de drain ($25_1$) du troisième transistor MOS (24) constituent un premier pôle (M) d'une sortie bi-polaire, et celle entre la dernière zone de semi-conducteur de drain ($9_m$) du deuxième transistor MOS (11) et la dernière zone de semi-conducteur de drain ($25_m$) du troisième transistor MOS constituent un deuxième pôle (Q) de la sortie bi-polaire de l'élément à effet Hall.

6. Elément à effet Hall, selon l'une des revendications de 1 à 5, caractérisé en ce qu'il est une partie d'un compteur d'électricité.

7. Elément à effet Hall, selon la revendication 6, caractérisé en ce que le champ magnétique produit par le courant consommé et à mesurer est apprécié à l'aide d'un champ magnétique de référence et les passages par zéro de la différence entre les deux champs magnétiques sont exploités.

8. Elément à effet Hall, selon la revendication 6, caractérisé en ce que le champ magnétique produit par le courant consommé et à mesurer est compensé à l'aide d'un champ magnétique de compensation et un courant de compensation alimentant ce champ magnétique de compensation est ensuite exploité.

9. Elément à effet Hall, selon la revendication 7 ou 8, caractérisé en ce que tous les champs magnétiques sont produits par des courants, qui parcourent des conducteurs plats, qui sont disposés à proximité de la surface de l'élément à effet Hall servant de détecteur de champ magnétique.

10. Elément à effet Hall, selon la revendication 9, caractérisé en ce que les conducteurs plats sont cintrés en forme d'U et qu'ils entourent le détecteur de champ magnétique monté dans un coffret.

11. Elément à effet Hall, selon l'une des revendications de 7 à 10, caractérisé en ce que tous les contacts électroniques nécessaires sont intégrés dans le même substrat que celui dans lequel l'élément à effet Hall est aussi intégré.

12. Elément à effet Hall, selon l'une des revendications de 7 à 11, caractérisé en ce que le substrat contenant l'élément à effet Hall est disposé dans ou à proximité immédiate de l'entrefer d'un noyau magnétique, avec sa surface perpendiculaire aux champs magnétiques.

13. Elément à effet Hall, selon l'une des revendications de 7 à 12, caractérisé en ce que le courant à mesurer est amené à une inductance de passage, de sorte qu'une partie du courant à mesurer soit écartée de l'élément à effet Hall à l'aide d'un shunt.

14. Elément à effet Hall, selon l'une des revendications de 7 à 12, caractérisé en ce que le courant à mesurer est amené à un circuit de mesure en pont de façon telle que seule la partie du courant à mesurer parcourant la branche diagonale du circuit de mesure en pont parvienne à l'élément à effet Hall.

15. Elément à effet Hall, selon l'une des revendications de 7 à 12, caractérisé en ce que le courant à mesurer est amené à un transformateur dont le bobinage primaire est constitué de conducteurs comportant deux résistances sensiblement égales et parcourues par des courants de sens contraire.

**Fig. 1**

**Fig. 2**

Fig. 3

Fig. 4

Fig. 5

0 106 943

Fig. 6

Fig. 7

# Fig. 8

# Fig. 9

Fig. 10

Fig. 11

## Fig. 12

## Fig. 13

0 106 943

# Fig. 14

# Fig. 15

7